# EUROPÄISCHE PATENTSCHRIFT

(11) **EP 0 551 562 B1**
(45) Veröffentlichungstag und Bekanntmachung des Hinweises auf die Patenterteilung: **13.11.1996**
(21) Anmeldenummer: 92113253.6
(22) Anmeldetag: 04.08.1992
(51) Int. Cl.: G01D 18/00, G01D 13/26, H02P 8/00

(54) **Synchronisierverfahren für ein Anzeigegerät mit elektronisch angesteuertem Schrittmotor**
Method for synchronising a display device having an electronically controlled stepper motor
Méthode de synchronisation d'un dispositif d'affichage à moteur pas-à-pas avec contrôle électronique

(30) Priorität: 11.01.1992 DE 4200551
(43) Veröffentlichungstag der Anmeldung: 21.07.1993
(73) Patentinhaber: VDO Adolf Schindling AG, D-60487 Frankfurt (DE)
(72) Erfinder: Kronenberg, Klaus, W-6231 Schwalbach (DE); Giron, Matthias, W-6000 Frankfurt/Main (DE); Belz, Robert, W-6200 Wiesbaden (DE); Obst, Wolfgang, W-6384 Schmitten 6 (DE)
(74) Vertreter: Klein, Thomas, Dipl.-Ing. (FH)

(56) Entgegenhaltungen:
- EP-A- 0 403 691
- DE-A- 3 306 642
- DE-A- 3 921 462

## Beschreibung

Die Erfindung bezieht sich auf ein Verfahren zur Synchronisation des Zählwerks einer elektronischen Steuereinrichtung mit der durch einen mechanischen Anschlag definierten Null-Position eines Zeigers in einem Anzeigegerät, das über ein Untersetzungsgetriebe von einem Schrittmotor mit zwei zueinander senkrechten Wicklungen und einem zweipoligen Rotor angetrieben wird, wobei die beiden Wicklungen alternierend an eine Spannungsquelle und an ein Meßwerk zur Ermittlung der in der nicht bestromten Wicklung induzierten Spannung angeschlossen werden und wobei der Zeiger schrittweise bis an den mechanischen Anschlag bewegt und das Zählwerk bei Ausbleiben einer Induktion auf Null gesetzt wird.

Gemäß der EP-A-0 403 691 ist ein Verfahren zur Erkennung einer vorbestimmten Zeigerstellung bei einer Anzeigeeinrichtung bekannt, bei welchem die Antriebssignale zum Weiterdrehen des Rotors so bemessen sind, daß der Rotor sich um einen vorbestimmten Winkel dreht. In einem Testabschnitt werden aufeinanderfolgende Ausgangssignale miteinander verglichen.

Ein solches Verfahren ist in der DE-OS 39 21 462 beschrieben. Wegen der Zwischenschaltung des Getriebes kann man aus der Position des Rotors im Schrittmotor keine sicheren Rückschlüsse auf die Position des Zeigers im Anzeigegerät ziehen. Letztere wird nur durch das Zählwerk der elektronischen Steuereinrichtung repräsentiert, dessen Inhalt jedoch aus verschiedenen Gründen gestört sein kann. Damit daraus keine Fehlanzeigen entstehen können, muß das Zählwerk immer wieder mit der Zeigerposition synchronisiert werden, wozu bei dem bekannten Verfahren die durch einen mechanischen Anschlag definierte Nullposition des Zeigers in Verbindung mit einem Prüfprogramm benutzt wird, bei dem der Schrittmotor solange im Sinne einer Zeigerbewegung in Richtung Null-position angesteuert wird, bis das Ende der Zeigerbewegung am Ausbleiben einer induzierten Spannunng in der jeweils nicht zum Antrieb des Zeigers bestromten Wicklung des Schrittmotors festgestellt wird. Danach kann das Zählwerk auf Null bzw. auf den zur Nullposition des Zeigers gehörenden Wert gesetzt werden.

Im Rahmen dieses Verfahrens werden die Wicklungen des Schrittmotors alternierend mit der vollen Antriebsspannung beaufschlagt und an ein Meßwerk angeschlossen. Bei zwei senkrecht zueinander angeordneten Wicklungen ergeben sich dabei 90°-Schritte des zweipoligen Rotors. Da das Prüfverfahren auf der Auswertung der induzierten Spannung beruht, müssen die einzelnen Rotorschritte eine bestimmte Mindestgröße haben, damit die induzierte Spannung groß genug ist, um sicher von einem Ausbleiben der Induktion unterschieden werden zu können.

Das bekannte Verfahren arbeitet zufriedenstellend, wird aber noch als verbesserungsbedürftig angesehen. Pro Rotorumdrehung fallen bei 90°-Schritten vier Umschaltungen und vier Prüfroutinen an, was schaltungstechnisch zu kompliziert ist. Es besteht somit die Aufgabe, das eingangs genannte Verfahren so weiterzubilden, daß die angestrebte Synchronisation mit deutlich reduziertem Aufwand erreicht werden kann.

Erfindungsgemäß wird die Aufgabe durch die Merkmale des kennzeichens des Patentanspruchs 1 gelöst.

Durch die Zuordnung einer bestimmten Ausrichtung des Rotors zur Nullposition des Zeigers wird eine Art Vorsynchronisation erreicht, durch die sichergestellt ist, daß die Null-position des Zeigers zwangsläufig nur bei einem bestimmten Schritt des Rotors erreicht werden kann, daß bei 90°-Schritten also jeweils nur einer von vier Schritten überprüft werden muß und der Schaltungsaufwand auf 50% des bekannten Verfahrens reduziert wird, weil nur noch eine der beiden Wicklungen alternierend an die Spannungsquelle und an das Meßwerk angeschlossen werden muß.

Vorteilhafte Ausgestaltungen und Anwendungen des Verfahrens sind in den Ansprüchen 2 bis 5 beschrieben.

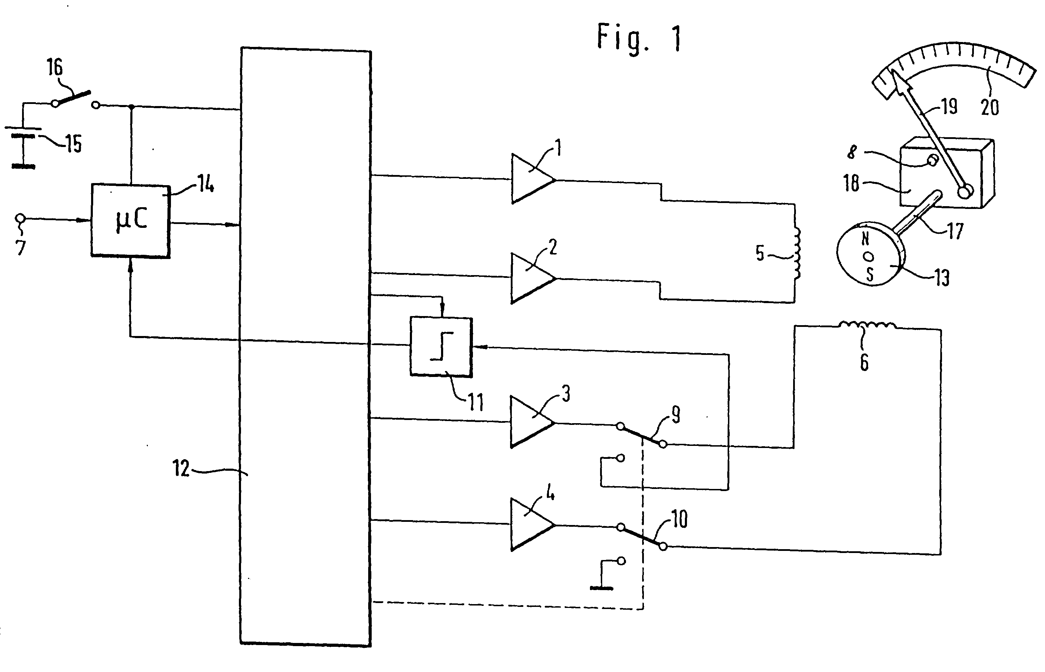

Weitere Einzelheiten werden anhand der in Fig. 1 dargestellten Schaltungsanordnung näher erläutert.

Für die Ansteuerung der beiden Wicklungen 5, 6 des Schrittmotors sind vier Treiberstufen 1, 2, 3, 4 vorgesehen. Der zweipolige Rotor 13 des Schrittmotors wird in bekannter Weise durch wechselnde Magnetfelder in den Wicklungen 5, 6 angetrieben. Er bewegt mittels einer Welle 17 und eines Getriebes 18 den Zeiger 19 über eine Skala 20 des Anzeigegeräts. Wenn der Zeiger 19 am Anschlag 8 anliegt, weist seine Spitze auf den Skalenanfang, d.h. auf die Nullposition des Meßbereichs. Die Treiberstufen 1,2,3,4 werden von der elektronischen Steuereinrichtung 12 angesteuert, die ebenso wie der Mikrocomputer 14 über den Schalter 16 an eine Spanungsquelle 15 angeschlossen ist. Mit 7 ist der Eingang für das Meßsignal gekennzeichnet.

Zwischen den Treiberstufen 3 und 4 und der Wicklung 6 sind Schalter 9 und 10 vorgesehen, mittels derer die Wicklung 6 entweder mit den Treiberstufen 3 und 4 oder mit einem Meßwerk 11 verbunden werden kann. Erfindungsgemäß erfolgt das Umschalten auf das Meßwerk 11 während des Synchronisierverfahrens jeweils nur in der um einen Schritt auf die bestimmte Ausrichtung des Rotors folgenden Position, die beim Zusammenbau von Schrittmotor und Anzeigegerät durch Zuordnung zur Nullposition des Zeigers 19 festgelegt wird.

## Patentansprüche

1. Verfahren zur Synchronisation des Zählwerkes einer elektronischen Steuereinrichtung (12) mit der durch einen mechanischen Anschlag (8) definierten Nullposition eines Zeigers (19) in einem Anzeigegerät, das über ein Untersetzungsgetriebe (18) von einem Schrittmotor mit zwei zueinander senkrechten Wicklungen (5, 6) und einem zweipoligen Rotor (13) angetrieben wird, wobei die beiden Wicklungen (5, 6) altemierend an eine Spannungsquelle (15) und an ein Meßwerk (11) zur Ermittlung der in der nicht bestromten Wicklung induzierten Spannung angeschlossen werden und wobei der Zeiger (19) schrittweise bis an den mechanischen Anschlag (8) bewegt und das Zählwerk bei Ausbleiben einer Induktion auf Null gesetzt wird, dadurch gekennzeichnet, daß das Umschalten auf das Meßwerk (11) während des Synchronisierverfahrens jeweils nur in der um einen Schritt auf eine bestimmte Ausrichtung des Rotors (13) folgenden Position erfolgt, die beim Zusammenbau von Schrittmotor und Anzeigegerät durch Zuordnung zur Nullposition des Zeigers (19) festgelegt wird.

2. Verfahren nach Anspruch 1, dadurch gekennzeichnet, daß es gestartet wird, indem die Wicklungen des Schrittmotors entsprechend der ausgewählten elektrischen Position des Rotors bestromt werden.

3. Verfahren nach Anspruch 1 oder 2, dadurch gekennzeichnet, daß es bei jeder Inbetriebnahme und bei jeder Außerbetriebsetzung des Anzeigegeräts durchgeführt wird.

4. Verfahren nach Anspruch 1 oder 2, dadurch gekennzeichnet, daß es jedesmal dann durchgeführt wird, wenn das Eingangssignal für das Anzeigegerät der Null-Position des Zeigers entspricht.

5. Verfahren nach einem der Ansprüche 1 bis 4, dadurch gekennzeichnet, daß die elektronische Steuereinrichtung das Verfahren startet, überwacht und beendet.

## Claims

1. Process for synchronisation of the counter of an electronic control device (12) with a zero position of an indicator (19) in a display unit, which is defined by a mechanical stop (8) and driven via a reduction gearing (18) by a step motor with two windings (5, 6) vertical to each other and a two-pole rotor (13); both windings (5, 6) are altematingly connected to a power source (15) and to a measuring device (11) for determining a potential in the uncharged winding, and the indicator (19) is moved in steps up to the mechanical stop (8), and the counter is set to zero in the absence of an induction, **characterised in that** switching over to the measuring unit (11) during the synchronisation process is carried out respectively only in a position following by one step a specified alignment of the rotor (13) which is set during assembly of step motor and indicator by association to the zero position of the indicator (19).

2. Process according to Claim 1, **characterised in that** it is started in that the windings of the step motor are charged according to a chosen electrical position of the rotor.

3. Process according to Claim 1 or 2, **characterised in that** it is carried out with each activation and de-activation of the indicator unit.

4. Process according to Claim 1 or 2, **characterised in that** it is always carried out when the input signal for the indicator corresponds with the zero position of the indicator.

5. Process according to one of Claims 1 to 4, **characterised in that** the electronic control device starts, monitors and terminates the process.

## Revendications

1. Procédé de synchronisation de l'agencement de comptage d'un dispositif électronique de contrôle et de commande (12) avec la position zéro de l'aiguille (19) d'un dispositif d'affichage, position définie par une butée mécanique (8), lequel dispositif d'affichage est entraîné par l'intermédiaire d'un engrenage réducteur (18) au moyen d'un moteur pas à pa comportant deux enroulements (5, 6) perpendiculaires l'un à l'autre et un rotor bipolaire (13), les deux enroulements (5, 6) étant connectés en alternance à une source de tension (15) et à un agencement de mesure (11) en vue d'apprécier la tension induite dans l'enroulement qui n'est pas alimenté en courant, et l'aiguille (19) étant déplacée pas à pas jusqu'à la butée mécanique, l'agencement de comptage étant mis à zéro lors de l'absence d'induction, caractérisé en ce que la commutation sur l'agencement de mesure (11) n'étant effectuée au cours du processus de synchronisation, chaque fois, que dans la position qui suit d'un pas le calage déterminé du rotor (13), position qui est fixée, lors de l'assemblage du moteur pas à pas et du dispositif d'affichage, par l'affectation de la position zéro de l'aiguille (19).

2. Procédé selon la revendication 1, caractérisé en ce qu'il est mis en route en alimentant les enroulements du moteur pas à pas en correspondance avec la position électrique sélectionnée du rotor.

3. Procédé selon la revendication 1 ou 2, caractérisé en ce que ce procédé est mis en oeuvre lors de chaque mise en marche du dispositif d'affichage et lors de chaque mise à l'arrêt de celui-ci.

4. Procédé selon la revendication 1 ou 2, caractérisé en ce que ce procédé est mis en oeuvre chaque fois que le signal d'entrée destiné au dispositif d'affichage correspond à la position zéro de l'aiguille.

5. Procédé selon l'une des revendications 1 à 4, caractérisé en ce que le dispositif électronique de commande fait débuter le processus, le surveille et l'arrête.
